# EUROPEAN PATENT SPECIFICATION

(11) **EP 2 168 928 B1**
(45) Date of publication and mention of the grant of the patent: **17.12.2014**
(21) Application number: 09170786.9
(22) Date of filing: 21.09.2009
(51) Int. Cl.: C03C 14/00, H05K 1/03, H05K 3/46

(54) **Glass Ceramic Substrate**
Glaskeramiksubstrat
Substrat vitrocéramique

(30) Priority: 26.09.2008 JP 2008248825; 31.08.2009 JP 2009200263
(43) Date of publication of application: 31.03.2010
(73) Proprietor: TDK Corporation, Tokyo 108-0023 (JP)
(72) Inventor: Kobuke, Hisashi, Chuo-ku Tokyo 103-8272 (JP); Kanada, Isao, Chuo-ku Tokyo 103-8272 (JP); Takahashi, Yusuke, Chuo-ku Tokyo 103-8272 (JP)
(74) Representative: Grünecker, Kinkeldey, Stockmair & Schwanhäusser

(56) References cited:
- EP-A- 0 718 249
- US-A- 5 132 256
- US-A- 5 342 674
- US-A1- 2007 049 681
- DATABASE WPI Week 200467 Thomson Scientific, London, GB; AN 2004-680303 XP002562312 -& JP 2004 256345 A (KYOCERA CORP) 16 September 2004 (2004-09-16)

## Description

### Field of the Invention

The present invention relates to a glass ceramic substrate.

### Related Background Art

Wiring substrates using low-temperature fired ceramics obtained by firing a composition containing a glass component and a filler component are known as wiring substrates for use in electronic devices. For these wiring substrates, attempts have been made to reduce the dielectric constant and improve the mechanical strength by using alumina as a filler component (see, for example, Japanese Patent Laid-Open No. 2004-256345).

US 5,342,674; US 5,132,256; and US 2007/0049681 A1 describe ceramic compositions, and rubber compositions, respectively.

### SUMMARY OF THE INVENTION

However, prior art wiring substrates such as those disclosed in Japanese Patent Laid-Open No. 2004-256345 have not exhibited a sufficient strength, and require a further improvement.

Accordingly, an object of the present invention is to provide a glass ceramic substrate having a sufficiently improved strength.

In order to achieve the above-mentioned object, the present invention provides a glass ceramic substrate containing a glass component and a plate-like alumina filler dispersed in the glass component, wherein the plate-like alumina filler has an average plate diameter of 0.1 to 20 µm and an average aspect ratio of 50 to 80, and wherein the plate-like alumina filler has a content of 22 to 35% by volume based on a total amount of the glass component and plate-like alumina filler.

The glass ceramic substrate of the present invention having the above-mentioned features exhibits an improved strength over prior art glass ceramic substrates. The present inventors assume the reason for this effect to be as follows. The glass ceramic substrate of the present invention contains 22 to 35% by volume of the plate-like alumina filler having an average plate diameter of 0.1 to 20 µm and an average aspect ratio of 50 to 80, based on the total amount of the glass component and plate-like alumina filler. The plate-like alumina filler with this shape has excellent dispersibility and orientation, and can suppress local concentration of stress, as compared with alumina fillers with other shapes. Therefore, by incorporating a specific amount of the plate-like alumina filler with this shape into a glass ceramic substrate, the strength of the glass ceramic substrate can be improved. The reason for the above-mentioned effect, however, is not limited to that stated herein.

According to the present invention, a glass ceramic substrate having a sufficiently improved strength can be provided.

### BRIEF DESCRIPTION OF THE DRAWINGS

FIG. 1 is a cross section showing a preferred embodiment of a glass ceramic multilayer substrate having a glass ceramic substrate of the present invention;
FIG 2 is a cross section for illustrating a step of the process for manufacturing the glass ceramic multilayer substrate 10 shown in FIG. 1;
FIG. 3 is a cross section for illustrating a step of the process for manufacturing the glass ceramic multilayer substrate 10 shown in FIG. 1;
FIG. 4 is a cross section for illustrating a step of the process for manufacturing the glass ceramic multilayer substrate 10 shown in FIG. 1;
FIG. 5 is a cross section for illustrating a step of the process for manufacturing the glass ceramic multilayer substrate 10 shown in FIG. 1; and
FIG. 6 is a cross section for illustrating a step of the process for manufacturing the glass ceramic multilayer substrate 10 shown in FIG. 1.

### DESCRIPTION OF THE PREFERRED EMBODIMENTS

Preferred embodiments of the present invention will be described below, referring to the drawings, as needed. In the description of the drawings, identical or corresponding elements are denoted by identical reference numerals, and the same description is omitted.

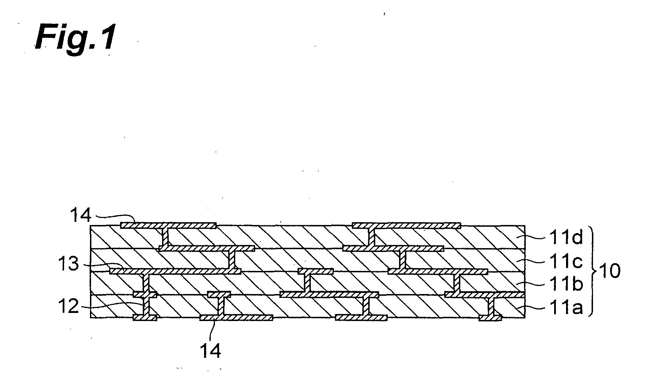

FIG. 1 is a cross section showing a preferred embodiment of a glass ceramic multilayer substrate having a glass ceramic substrate of the present invention. The glass ceramic multilayer substrate 10 shown in FIG. 1 has a stacked structure including glass ceramic substrates 11a, 11b, 11c, and 11d in this order. Further, the glass ceramic multilayer substrate 10 includes an inner conductor 13 provided between adjacent glass ceramic substrates; surface conductors 14, individually provided on outermost surfaces of glass ceramic layers 11a and 11d, which are the outermost layers; and via-conductors 12 that allow electrical conduction between the inner conductor 13 and surface conductors 14.

Each of the glass ceramic substrates 11a to 11d contains a glass component and a plate-like alumina filler dispersed in the glass component. The content of the plate-like alumina filler is 22 to 35% by volume based on the total content of the glass component and plate-like alumina filler. Each of these components is described in detail below.

### <Glass Component>

Two types of glass components can be mentioned, for example, (1) an amorphous glass-based material and (2) a crystallized glass-based material. The (2) crystallized glass-based material is a material obtained by allowing many microcrystals to be deposited in a glass component during heating and firing, and is also referred to as a glass ceramic.

Of the above-mentioned (1) amorphous glass-based material and (2) crystallized glass-based material, the (2) crystallized glass-based material is preferable as the glass component of this embodiment. Usable as the (2) crystallized glass-based material are, for example, (i) a glass component containing SiO₂, B₂O₃, Al₂O₃, and an alkali earth metal oxide; and (ii) a diopside crystal glass component containing SiO₂, CaO, MgO, Al₂O₃, and CuO.

In the (i) glass component containing SiO₂, B₂O₃, Al₂O₃, and an alkali earth metal oxide, the SiO₂ content is preferably 46 to 60% by mass, and more preferably 47 to 55% by mass, based on the total amount of the glass component. If the SiO₂ content is less than 46% by mass, vitrification tends to be difficult, whereas if it exceeds 60% by mass, the melting point tends to be high, making the low-temperature sintering difficult.

The B₂O₃ content is preferably 0.5 to 5% by mass, and more preferably 1 to 3% by mass, based on the total amount of the glass component. If the B₂O₃ content exceeds 5% by mass, the moisture resistance tends to decrease, whereas if it is less than 0.5% by mass, the vitrification temperature tends to be high, and the density tends to be low.

The Al₂O₃ content is preferably 6 to 17.5% by mass, and more preferably 7 to 16.5% by mass, based on the total amount of the glass component. If the Al₂O₃ content is less than 6% by mass, the strength tends to be slightly low, whereas if it exceeds 17.5% by mass, vitrification tends to be difficult. The alkali earth metal oxide content is preferably 25 to 45% by mass, and more preferably 30 to 40% by mass, based on the total amount of the glass component.

Examples of the alkali earth metal oxide include MgO, CaO, BaO, and SrO. These alkali earth metal oxides can be used alone or in a combination of two or more. Among the above, a combination of SrO and other alkali earth metal oxide(s) is preferably used. The use of SrO and at least one alkali earth metal oxide selected from the group consisting of CaO, MgO, and BaO allows the viscosity of molten glass to decrease, and the range of sintering temperatures to expand, making the manufacture easier.

The SrO content is preferably 60% by mass or more, and more preferably 80% by mass or more, based on the total amount of the alkali earth metal oxides. If the SrO content is less than 60% by mass, the difference in thermal expansion coefficient between the glass component and plate-like alumina filler will become large, so that the strength of the glass ceramic substrate tends to decrease.

The total amount of CaO, MgO, and BaO is preferably 1% by mass or more, based on the total amount of the alkali earth metal oxides. Moreover, the content of each of CaO and MgO is preferably 0.2% by mass or more, and more preferably 0.5% by mass or more, based on the total amount of the alkali earth metal oxides. Furthermore, the CaO content is preferably less than 10% by mass, and the MgO content is preferably 4% by mass or less, based on the total amount of the alkali earth metal oxides. If the CaO and MgO contents exceed these ranges, the thermal expansion coefficient will be too low, so that the strength of the glass ceramic substrate tends to decrease, and controlling the degree of crystallinity of the glass tends to be difficult. In order to achieve both ease of manufacture and strength of the glass ceramic substrate, the total amount of CaO and MgO is preferably less than 10% by mass, and the CaO content is more preferably 5% by mass or less, based on the total amount of the alkali earth metal oxides.

Moreover, the BaO content is preferably 5% by mass or less, based on the total amount of the alkali earth metal oxides. If the BaO content exceeds 5% by mass, the dielectric constant tends to be high.

In the (ii) diopside crystal glass component containing SiO₂, CaO, MgO, Al₂O₃, and CuO, diopside is deposited as main crystals.

In the diopside crystal glass component, SiO₂ is the network former of the glass, and is also a component forming diopside crystals.
The SiO₂ content is preferably 40 to 65% by mass, and more preferably 45 to 65% by mass, based on the total amount of the diopside crystal glass component. If the SiO₂ content is less than 40% by mass, vitrification tends to be difficult, whereas if it exceeds 65% by mass, the density tends to be low.

In the diopside crystal glass component, CaO is a component forming diopside crystals. The CaO content is preferably 20 to 35% by mass, and more preferably 25 to 30% by mass, based on the total amount of the diopside crystal glass component. If the CaO content is less than 20% by mass, the dielectric loss tends to be high, whereas if it exceeds 35% by mass, vitrification tends to be difficult.

In the diopside crystal glass component, MgO is also a component forming diopside crystals. The MgO content is preferably 11 to 30% by mass, and more preferably 12 to 25% by mass, based on the total amount of the diopside crystal glass component. If the MgO content is less than 11 % by mass, the deposition of crystals tends to be difficult, whereas if it exceeds 30% by mass, vitrification tends to be difficult.

In the diopside crystal glass component, Al₂O₃ is a component that adjusts the crystallinity of the glass component. The Al₂O₃ content is preferably 0.5 to 10% by mass, and more preferably 1 to 5% by mass, based on the total amount of the diopside crystal glass component. If the Al₂O₃ content is less than 0.5% by mass, the crystallinity tends to be too high, making glass-forming difficult, whereas if it exceeds 10% by mass, the deposition of diopside crystals tends to be difficult.

In the diopside crystal glass component, CuO is a component that donates electrons to Ag, thereby preventing diffusion of Ag into the glass ceramic. The CuO content is preferably 0.01 to 1.0% by mass based on the total amount of the diopside crystal glass component. If the CuO content is less than 0.01 % by mass, the above-mentioned effect tends to be insufficient, whereas if it exceeds 1.0% by mass, the dielectric loss tends to be too high.

In the diopside crystal glass component, SrO, ZnO, and TiO₂ are components added to facilitate vitrification. The content of each of these components is preferably 0 to 10% by mass, and more preferably 0 to 5%, based on the total amount of the diopside crystal glass component. If the content of each of these components exceeds 10% by mass, the crystallinity tends to be low, so that the amount of diopside deposition will be small to increase the dielectric loss.

The diopside crystal glass component may additionally contain component(s) other than the above-mentioned components in such a range that its characteristics such as dielectric loss are not impaired.

Of the (i) and (ii) glass components, the (ii) glass component is preferred to provide a further improved strength.

### <Alumina Filler>

In this embodiment, plate-like alumina having an average plate diameter of 0.1 to 20 µm and an average aspect ratio of 50 to 80 can be used as the plate-like alumina filler contained in the glass ceramic substrates 11a to 11d. The incorporation of this material into the glass ceramic substrates 11a to 11d, in addition to the glass component, improves the strength of the glass ceramic substrates 11a to 11d.

The term "plate diameter" as used herein represents the maximum length of the plane surfaces of the plate-like alumina filler, and the term "thickness" represents the maximum length in the vertical direction to the plane surfaces. The average plate diameter and average thickness can be determined as the average values of the plate diameters and thicknesses, respectively, of five-hundred alumina filler plates that are randomly extracted from an electron microscope image. The average aspect ratio is calculated by (the average plate diameter)/(the average thickness).

The planar shape of the plate-like alumina filler is preferably circular, oval, polygonal that is nearly circular or oval, or the like, which has low anisotropy. In order to improve the strength of the glass ceramic substrates 11a to 11d, the planar shape of the plate-like alumina filler is more preferably a regular hexagon (a hexagonal plate shape).

In order to further improve the strength of the glass ceramic substrates, the average plate diameter of the plate-like alumina filler is preferably 1 to 10 µm, and more preferably 2 to 7 µm. Further, from the same standpoint, the average aspect ratio of the plate-like alumina filler is preferably 50 to 75, and more preferably 70 to 75.

While each of the components has been described above, the glass ceramic substrates 11a to 11d may further contain a ceramic filler other than the plate-like alumina filler. Examples of ceramic fillers other than the plate-like alumina filler include spherical or plate-like fillers formed of at least one material selected from the group consisting of, for example, magnesia, spinel, silica, mullite, forsterite, steatite, cordierite, strontium feldspar, quartz, zinc silicate, zirconia, and titania.
In order to impart strength to the glass ceramic substrates, the proportion of the plate-like alumina filler is preferably 80% by volume or more of all of the fillers.

In the glass ceramic substrates 11a to 11d, the plate-like alumina filler is preferably oriented so that the plane surfaces of the plate-like alumina filler are in parallel with (in the horizontal direction to) a main surface of the glass ceramic. The orientation of the plate-like alumina filler in this direction allows the strength of the glass ceramic substrates to be even further improved.

While preferred embodiments of the glass ceramic multilayer substrate having the glass ceramic substrates of the invention have been described above, the present invention is not limited to the above-described embodiments. For example, any one of the glass ceramic substrates 11a to 11d may be used as the glass ceramic substrate of the invention. Further, while the glass ceramic multilayer substrate 10 shown in FIG. 1 includes the four glass ceramic substrates 11a to 11d, the number of the stacked glass ceramic substrates is not limited thereto.

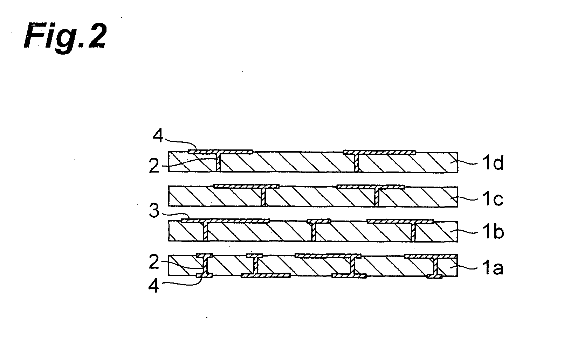

Next, referring to FIGS. 2 to 6, a process for manufacturing the glass ceramic multilayer substrate 10 shown in FIG. 1 is described.
FIGS. 2 to 6 are cross sections for illustrating steps of the process for manufacturing the glass ceramic multilayer substrate 10 shown in FIG. 1.

First, as shown in FIG. 2, substrate green sheets 1a to 1d having via-conductor patterns 2, an inner conductor pattern 3, and surface conductor patterns 4 are prepared. While four substrate green sheets 1a to 1d are prepared herein, the number of stacked substrate green sheets is not limited thereto; the number of substrate green sheets prepared may be determined according to the number of substrates to be stacked.

Each of the substrate green sheets 1a to 1d contains a plate-like alumina filler having an average plate diameter of 0.1 to 20 µm and an average aspect ratio of 50 to 80. The substrate green sheets 1a to 1d can be formed as follows.

The plate-like alumina filler can be obtained by a reaction step in which, for example, aluminate and an acid aluminum salt are reacted in an aqueous state; and a firing step in which a mixture containing alumina and/or hydrated alumina and a neutralizing metal salt is produced, and the mixture is fired at 1000 to 1600°C.

In the reaction step, sodium hydroxide is first dissolved in water to prepare a sodium hydroxide solution. Metal aluminum and disodium hydrogenphosphate are mixed into the sodium hydroxide solution and stirred, thus preparing a mixed solution in which the metal aluminum and disodium hydrogenphosphate are dissolved. An aqueous aluminum sulfate solution is added with stirring to this mixed solution until the pH becomes 6 to 8, thus giving a milky gel mixture. This mixture is subsequently evaporated to dryness.

In the firing step, the mixture evaporated to dryness is fired for 2 to 8 hours at 1000 to 1600°C. The thus-fired product is further washed by adding water and filtered, and the resulting solids are dried. Thus, a plate-like alumina filler having an average plate diameter of 0.1 to 20 µm and an average aspect ratio of 50 to 80 can be obtained.

The thus-obtained plate-like alumina filler is mixed with, for example, a glass powder and an organic vehicle containing a binder, a solvent, a plasticizer, a dispersant, and the like, to prepare a dielectric paste in slurry form.

Examples of binders include polyvinyl butyral resin and methacrylate resin; and examples of plasticizers include dibutyl phthalate. Examples of solvents include toluene and methyl ethyl ketone.

Each of the substrate green sheets 1a to 1d can be formed by, for example, forming a film of the prepared dielectric paste on a support such as a polyethylene terephthalate (PET) sheet, using doctor blading or the like. By forming the film using doctor blading, the plane surfaces of the plate-like alumina filler can be oriented in parallel with (in the horizontal direction to) a main surface of each substrate green sheet, allowing the formation of a glass ceramic substrate having a further improved strength.

Next, conductor patterns (circuit patterns, electrode pads, via-holes, and the like) are formed on the substrate green sheets 1a to 1d, so as to match desired circuits. Specifically, through-holes (via-holes) are formed in predetermined positions of the substrate green sheets 1a to 1d, and the via-holes are filled with a conductive paste to form via-conductor patterns 2. Moreover, a conductive paste is printed in a predetermined pattern on the surface of each of the substrate green sheets 1b and 1c that are to be inner layers, to form an inner conductor pattern 3. Further, surface conductor patterns 4 are formed on the substrate green sheets 1a and 1d that are to be placed on the outermost sides. Note that the substrate green sheets 1a to 1d may have electronic devices (inductors, capacitors, and the like), as needed.

The conductive paste used to form conductor patterns is prepared by, for example, mixing an organic vehicle and a conductive material composed of any of various conductive metals or alloys, such as Ag, Ag-Pd alloy, Cu, and Ni. The organic vehicle used in the conductive paste contains a binder and a solvent as principal components. The proportions and the like of the binder and solvent relative to the conductive material may be determined as desired; typically, the proportion of the binder is 1 to 15% by mass, and the proportion of the solvent is 10 to 50% by mass, relative to the conductive material. Additive(s) selected from various dispersants, plasticizers, and the like may be added to the conductive paste, as needed.

According to the above-described process, the substrate green sheets 1a to 1d having the via-conductor patterns 2, inner conductor pattern 3, and surface conductor patterns 4 can be formed.

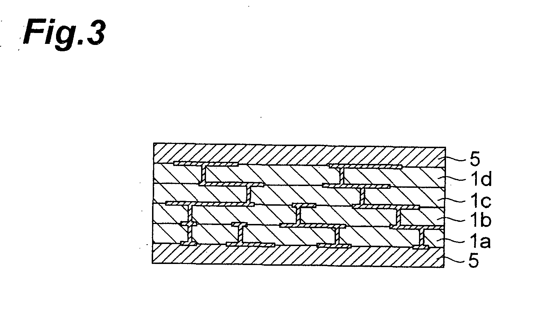

Next, as shown in FIG. 3, the substrate green sheets 1a, 1b, 1c, and 1d having the via-conductor patterns 2, inner conductor pattern 3, and surface conductor patterns 4 are stacked in this order to provide a stack. A pair of shrinkage-inhibiting green sheets 5 serving as restraint layers are placed so as to sandwich the stack between them in a stacking direction. By sandwiching the stack including the substrate green sheets 1a to 1d between the shrinkage-inhibiting green sheets 5, it is possible to inhibit the shrinkage of the stack in the in-plane direction (the direction vertical to the stacking direction) during firing described below.

Further, by thus inhibiting the shrinkage of the stack in the in-plane direction, it is possible to reduce the disorder of the orientation of the plate-like alumina filler caused by variations in shrinkage. That is, it is possible to maintain the orientation of the plate-like alumina filler oriented before firing. Accordingly, a highly oriented sintered body can be obtained, allowing the formation of a glass ceramic substrate with a further improved strength.

Examples of materials used for the shrinkage-inhibiting green sheets 5 serving as restraint layers (hereinafter referred to as "shrinkage-inhibiting materials") include tridymite, cristobalite, quartz, fused silica, alumina, mullite, zirconia, aluminum nitride, boron nitride, magnesium oxide, silicon carbide, and calcium carbonate.

A material that does not shrink at the firing temperature of the substrate green sheets 1a to 1d is preferably used as a shrinkage-inhibiting material. Among these materials, tridymite is preferred because it functions as restraint layers, and can easily be peeled. Further, in order to enhance the peelability for a thin glass ceramic substrate, calcium carbonate may further be stacked on tridymite.

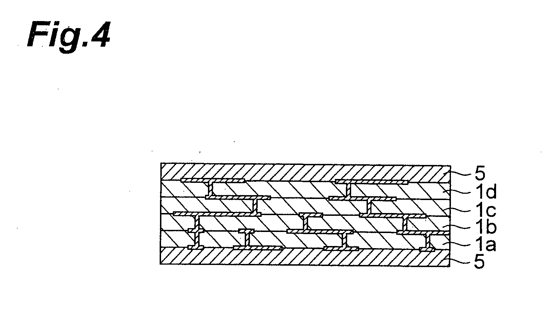

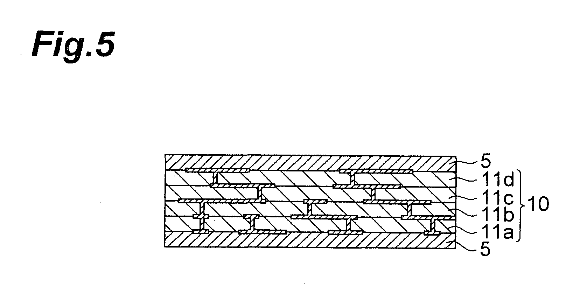

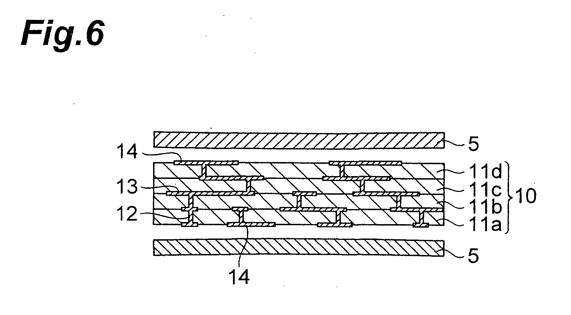

Next, as shown in FIG. 4, the stack (temporary stack) having the shrinkage-inhibiting green sheets 5 on both sides thereof is pressed. By firing the stack subsequent to the pressing, as shown in Fig. 5, the substrate green sheets 1a to 1d turn into ceramic substrates 11 a to 11d, and the via-conductor patterns 2 within the via holes turn into via-conductors 12. Moreover, the inner conductor pattern 3 turns into an inner conductor 13, and the surface conductor patterns 4 turn into surface conductors 14. Next, as shown in FIG. 6, the shrinkage-inhibiting green sheets 5 are peeled, thereby giving a glass ceramic multilayer substrate 10. At this point, a step of removing residues after firing (for example, a blast treatment or ultrasonic cleaning treatment) may be added, as needed.

When tridymite is used as the shrinkage-inhibiting material, the shrinkage-inhibiting green sheets 5 are naturally peeled after firing, because of a difference in thermal expansion.

While one embodiment of the process for manufacturing the glass ceramic multilayer substrate 10 shown in FIG. 1 has been described above, the process for manufacturing the glass ceramic multilayer substrate 10 is not limited to the above-described process. For example, the plate-like alumina filler may be contained in at least one of the substrate green sheets 1a to 1d. Note, however, that the plate-like alumina filler is preferably contained in any of the substrate green sheets 1a to 1d having through-holes filled with a conductive paste.

Further, while the shrinkage-inhibiting green sheets 5 are placed in the stack prior to firing in the above-described manufacturing process, the stack may be fired without placing the shrinkage-inhibiting green sheets 5 therein, to manufacture a glass ceramic multilayer substrate 10.

### EXAMPLES

The present invention is described in greater detail below based on Examples and Comparative Examples.

### (Example 1)

A glass powder (a crystallized glass powder depositing diopside, consisting primarily of SiO₂, CaO, MgO, Al₂O₃, and CuO) and a plate-like alumina filler were provided. Table 1 shows the average plate diameter, average thickness, and average aspect ratio of the plate-like alumina filler.

The glass powder (64.5 g) and plate-like alumina filler (35.5 g), as provided above, and an organic vehicle (61 g) were mixed to prepare a dielectric paste.

The composition of the organic vehicle was as follows: acrylic resin: 19.4 g; toluene: 59.1 g; ethanol: 3 g; and plasticizer (BPBG): 6.5 g.

Substrate green sheets were formed by forming a film of the prepared dielectric paste on a polyethylene terephthalate film using doctor blading.

Next, the substrate green sheets were stacked on one another and pressed at 74 MPa, after which the stack was fired in air for 1 hour at 900°C, thus giving a glass ceramic multilayer substrate. The thickness of the fired glass ceramic multilayer substrate was 0.2 mm, and the content of the plate-like alumina filler in the glass ceramic multilayer substrate was 30% by volume based on the total amount of the glass component and plate-like alumina filler.

The thus-prepared glass ceramic multilayer substrate was subjected to a three-point bending strength test according to JIS C2141. Specifically, one side of the glass ceramic multilayer substrate was supported at two points; a load was gradually applied to the intermediate position between the two points on the side opposite to the above-mentioned side; the load at which the glass ceramic multilayer substrate fractured was measured; and the three-point bending strength (MPa) was calculated based on the measured result. The bending strength was measured at 30 points, and the average value (average bending strength) was determined. The result is shown in Table 1.

### (Examples 2 and 3 and Comparative Examples 1 to 4)

Glass ceramic multilayer substrates were prepared in the same manner as in Example 1, except that the average plate diameter, average thickness, and average aspect ratio of each plate-like alumina filler were changed as shown in Table 1. The thickness of each of the fired glass ceramic multilayer substrates was 0.2 mm, and the content of the plate-like alumina filler in each glass ceramic multilayer substrate was 30% by volume based on the total amount of the glass component and plate-like alumina filler.

The bending strength of each of the prepared glass ceramic multilayer substrates was measured in the same manner as in Example 1. The measured results of the average bending strengths are shown in Table 1.

**[Table 1]**

| | Ex.1 | Ex.2 | Ex.3 | Comp. Ex. 1 | Comp. Ex. 2 | Comp. Ex. 3 | Comp. Ex. 4 |
|---|---|---|---|---|---|---|---|
| Average Plate Diameter (µm) | 2.0 | 5.0 | 7.0 | 0.6 | 2.0 | 5.0 | 10.0 |
| Average Thickness (µm) | 0.04 | 0.07 | 0.10 | 0.06 | 0.08 | 0.20 | 0.30 |
| Average Aspect Ratio | 50.0 | 71.4 | 70.0 | 10.0 | 25.0 | 25.0 | 33.0 |
| Average Bending Strength (MPa) | 410 | 432 | 458 | 350 | 363 | 386 | 351 |

### (Example 4)

A glass ceramic multilayer substrate was prepared in the same manner as in Example 1, except that firing was performed with a green sheet stack for the substrate being sandwiched between shrinkage-inhibiting green sheets containing tridymite, and the bending strength was measured. Table 2 shows the average plate diameter, average thickness, and average aspect ratio of the plate-like alumina filler; and the measured result of the average bending strength. The thickness of the fired glass ceramic multilayer substrates was 0.2 mm, and the content of the plate-like alumina filler in glass ceramic multilayer substrate was 30% by volume based on the total amount of the glass component and plate-like alumina filler.

### (Examples 5 and 6 and Comparative Examples 5 to 8)

Glass ceramic multilayer substrates according to Examples 5 and 6 and Comparative Examples 5 to 8 were prepared in the same manner as in Examples 2 and 3 and Comparative Examples 1 to 4, respectively, except that firing was performed with a green sheet stack for each substrate being sandwiched between shrinkage-inhibiting green sheets containing tridymite, and the bending strengths were measured. Table 2 shows the average plate diameters, average thicknesses, and average aspect ratios of the plate-like alumina fillers; and the measured results of the average bending strengths. The thickness of each of the fired glass ceramic multilayer substrates was 0.2 mm, and the content of the plate-like alumina filler in each glass ceramic multilayer substrate was 30% by volume based on the total amount of the glass component and plate-like alumina filler.

### (Example 7)

A glass ceramic multilayer substrate was prepared in the same manner as in Example 5, except that a material containing SiO₂, B₂O₃, Al₂O₃, and SrO was used as a glass powder, and the bending strength was measured.

Table 2 shows the average plate diameter, average thickness, and average aspect ratio of the plate-like alumina filler; and the measured result of the average bending strength. The thickness of the fired glass ceramic multilayer substrate was 0.2 mm, and the content of the plate-like alumina filler in the glass ceramic multilayer substrate was 30% by volume based on the total amount of the glass component and plate-like alumina filler.

**[Table 2]**

| | Ex. 4 | Ex. 5 | Ex. 6 | Ex. 7 | Comp. Ex. 5 | Comp. Ex.6 | Comp. Ex. 7 | Comp. Ex. 8 |
|---|---|---|---|---|---|---|---|---|
| Average Plate Diameter (µm) | 2.0 | 5.0 | 7.0 | 5.0 | 0.6 | 2.0 | 5.0 | 10.0 |
| Average Thickness (µm) | 0.04 | 0.07 | 0.10 | 0.07 | 0.06 | 0.08 | 0.20 | 0.30 |
| Average Aspect Ratio | 50.0 | 71.4 | 70.0 | 71.4 | 10.0 | 25.0 | 25.0 | 33.0 |
| Average Bending Strength (MPa) | 430 | 550 | 490 | 405 | 360 | 370 | 390 | 360 |

### (Examples 8 and 9 and Comparative Examples 9 and 10)

Glass ceramic multilayer substrates were prepared in the same manner as in Example 3, except that the content of the plate-like alumina filler in each glass ceramic multilayer substrate was changed, and the bending strengths were measured. Table 3 shows the content of each plate-like alumina filler based on the total amount of the glass component and plate-like alumina filler; the average plate diameter, average thickness, and average aspect ratio of the plate-like alumina filler; and the measured result of each average bending strength. The thickness of each of the fired glass ceramic multilayer substrates was 0.2 mm.

**[Table 3]**

| | Ex. 8 | Ex. 9 | Comp. Ex. 9 | Comp. Ex. 10 |
|---|---|---|---|---|
| Average Plate Diameter (µm) | 7.0 | 7.0 | 7.0 | 7.0 |
| Average Thickness (µm) | 0.10 | 0.10 | 0.10 | 0.10 |
| Average Aspect Ratio | 70.0 | 70.0 | 70.0 | 70.0 |
| Average Bending Strength (MPa) | 421 | 405 | 390 | 352 |
| Content of Plate-Like Alumina Filler (% by Volume) | 24 | 34 | 20 | 38 |

The results shown in Tables 1 to 3 confirmed that the glass ceramic multilayer substrates of Examples 1 to 9 are superior in three-point bending strength to the glass ceramic multilayer substrates of Comparative Examples 1 to 10.

## Claims

1. A glass ceramic substrate comprising a glass component and a plate-like alumina filler dispersed in the glass component,
wherein the plate-like alumina filler has an average plate diameter of 0.1 to 20 µm and an average aspect ratio of 50 to 80; and
wherein the plate-like alumina filler has a content of 22 to 35% by volume based on a total amount of the glass component and plate-like alumina filler.

## Patentansprüche

1. Glaskeramiksubstrat umfassend eine Glaskomponente und einen plättchenförmigen Aluminiumoxidfüllstoff, der in der Glaskomponente dispergiert ist,
wobei der plättchenförmige Aluminiumoxidfüllstoff einen mittleren Plättchendurchmesser von 0,1 bis 20 µm und ein mittleres Aspektverhältnis von 50 bis 80 aufweist; und
wobei der plättchenförmige Aluminiumoxidfüllstoff einen Gehalt von 22 bis 35 Voi.-%, bezogen auf eine Gesamtmenge der Glaskomponente und des plättchenförmigen Aluminiumoxidfüllstoffs, aufweist.

## Revendications

1. Substrat vitrocéramique comprenant un composant en verre et un matériau de remplissage en alumine de type plaquette dispersé dans le composant en verre,
dans lequel le matériau de remplissage en alumine de type plaquette présente un diamètre de plaquette moyen de 0,1 µm à 20 µm et un rapport d'aspect moyen de 50 à 80 ; et
dans lequel le matériau de remplissage en alumine de type plaquette présente une teneur de 22 % à 35 % en volume par rapport à la quantité totale du composant en verre et du matériau de remplissage en alumine de type plaquette.
